# EUROPEAN PATENT APPLICATION

(11) **EP 4 503 113 A1**
(43) Date of publication of application: **05.02.2025**
(21) Application number: 23779372.4
(22) Date of filing: 09.03.2023
(51) Int. Cl.: H01L 23/12, H05K 1/02, H05K 3/46

(54) **WIRING BOARD AND SEMICONDUCTOR DEVICE**

(30) Priority: 30.03.2022 JP 2022056183
(71) Applicant: Kyocera Corporation, Kyoto-shi, Kyoto 612-8501 (JP)
(72) Inventor: MATSUMOTO, Yuhei, Kyoto-shi, Kyoto 612-8501 (JP); YAMAMOTO, Sentarou, Kyoto-shi, Kyoto 612-8501 (JP); SHIBATA, Masamitsu, Kyoto-shi, Kyoto 612-8501 (JP); OTA, Natsuki, Kyoto-shi, Kyoto 612-8501 (JP)
(74) Representative: Viering, Jentschura & Partner mbB Patent- und Rechtsanwälte
(86) International application number: PCT/JP2023/009008
(87) International publication number: WO 2023/189345

(57) **Abstract**

A wiring board includes a layered body. The layered body includes a ceramic layer made of a ceramic and a base material wiring layer having an organic resin as a base material and including a wiring layer. The base material wiring layer includes a conductor wiring line made of copper foil on a surface on the ceramic layer side.

## Description

### TECHNICAL FIELD

The present disclosure relates to a wiring board and a semiconductor device.

### BACKGROUND OF INVENTION

Computers have been used for control of vehicles such as aircraft and trains. A semiconductor element such as large scale integration (LSI) is used in such computers. The semiconductor element is mounted in a package and incorporated in an electronic device from the viewpoint of protection from an external environment or prevention of failure.

As such a package, a ceramic package has been frequently used from the viewpoint of high rigidity. Examples of the ceramic package include a package made of alumina and a package made of a glass ceramic.

The ceramic package has high rigidity due to the nature of ceramic that is an insulating base material, and thus is hardly deformed. For this reason, deformation of the semiconductor element due to deformation of the package hardly occurs even during operation in which a temperature change is large.

### CITATION LIST

### PATENT LITERATURE

Patent Document 1: JP 2006-302990 A

### SUMMARY

A wiring board according to one aspect of an embodiment includes a layered body. The layered body includes a ceramic layer made of a ceramic and a base material wiring layer having an organic resin as a base material and including a wiring layer. The base material wiring layer includes a conductor wiring line made of copper foil on a surface on the ceramic layer side.

### BRIEF DESCRIPTION OF THE DRAWINGS

FIG. 1 is a plan view illustrating an example of a wiring board according to a first embodiment.
FIG. 2 is a cross-sectional view taken along line I-I illustrated in FIG. 1 as viewed in the direction of arrows.
FIG. 3 is a plan view illustrating an example of a semiconductor device according to a second embodiment.
FIG. 4 is a cross-sectional view taken along line II-II illustrated in FIG. 3 as viewed in the direction of arrows.
FIG. 5 is a plan view illustrating an example of a semiconductor device according to a third embodiment.
FIG. 6 is a cross-sectional view taken along line III-III illustrated in FIG. 5 as viewed in the direction of arrows.
FIG. 7 is a plan view illustrating an example of a semiconductor device according to a fourth embodiment.
FIG. 8 is a cross-sectional view taken along line IV-IV illustrated in FIG. 7 as viewed in the direction of arrows.
FIG. 9 is a cross-sectional view illustrating an example of a semiconductor device according to a fifth embodiment.
FIG. 10 is an enlarged view of a region V illustrated in FIG. 9.
FIG. 11 is a cross-sectional view illustrating a variation of a wiring board according to a sixth embodiment.

### DESCRIPTION OF EMBODIMENTS

Aspects (hereinafter described as "embodiments") for implementing a wiring board and a semiconductor device according to the present disclosure will be described below in detail with reference to the drawings. Note that the wiring board and the semiconductor device according to the present disclosure are not limited by these embodiments. Embodiments can be appropriately combined to the extent that they do not contradict each other in terms of processing content.

When a ceramic package is manufactured, first, a conductor paste containing a common material such as a ceramic powder is printed on a green sheet. Thereafter, the conductor paste is co-fired with the green sheet to form a conductor. For this reason, the ceramic package has room for improvement from the viewpoint of reducing the resistance of the conductor.

Therefore, it is expected to provide a wiring board and a semiconductor device that can reduce the resistance of the conductor while having high rigidity.

### First Embodiment

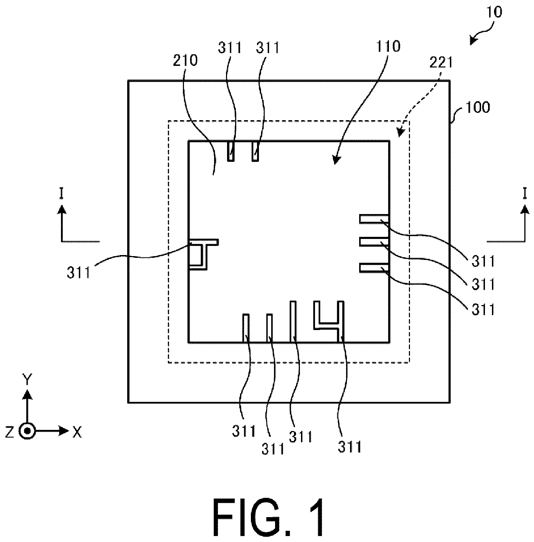

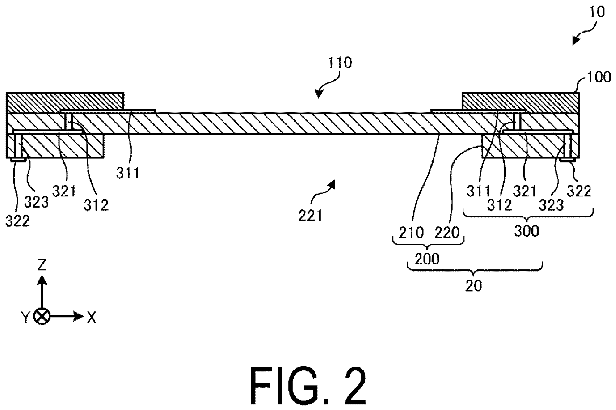

FIG. 1 is a plan view illustrating an example of a wiring board 10 according to the first embodiment. FIG. 2 is a cross-sectional view taken along line I-I illustrated in FIG. 1 as viewed in the direction of arrows. Note that hereinafter, XYZ coordinates are illustrated in the drawings. The Z axis direction corresponds to the layering direction of the wiring board 10. The XY plane including the X axis and the Y axis corresponds to the plane of the wiring board 10. FIG. 1 corresponds to a top view of the wiring board 10 as viewed in the Z axis positive direction.

As illustrated in FIGs. 1 and 2, the wiring board 10 according to the first embodiment includes a layered body including a ceramic layer 100 and a base material wiring layer 20. The ceramic layer 100 is made of a ceramic. The base material wiring layer 20 has an organic resin as a base material and includes wiring 300. The base material wiring layer 20 includes a first conductor wiring line 311 (an example of a conductor wiring line) made of copper foil on the surface on the ceramic layer 100 side.

In this manner, the wiring board 10 includes the first conductor wiring line 311 made of copper foil serving as a connection terminal on the surface of the base material wiring layer 20, and thus can reduce the resistance of the conductor. The wiring board 10 can have high rigidity by including the ceramic layer 100 separately from the base material wiring layer 20.

Hereinafter, the wiring board 10 will be described in detail.

### Ceramic Layer 100

The ceramic layer 100 has a ceramic as an insulating base material (first base material). The ceramic layer 100 includes a through hole 110 (first through hole). The through hole 110 is located in the center of the ceramic layer 100 in plan view (as viewed from the layering direction). Here, the center is a region centered on the center of gravity in the ceramic layer 100. Alternatively, when the ceramic layer has a quadrilateral shape, it is a region centered on a position where two diagonals intersect. When the ceramic layer has a circular shape, it is a region centered on an intersection point when two straight lines intersect each other at a right angle inside a circle.

The first base material is a ceramic base material made of a ceramic, for example. The first base material may be a ceramic of alumina or glass, for example. The first base material may be, for example, a dielectric such as cordierite, zirconia, barium titanate, strontium titanate, or calcium titanate, aluminum titanate, lead zirconate titanate (PZT), or the like. The first base material may have, for example, a plurality of ceramics.

The ceramic layer 100 is made of a first base material (ceramic). The ceramic layer 100 is made of a monolithic ceramic not containing a metal component such as a conductor. In this manner, since the ceramic layer 100 does not contain components other than a ceramic, it can exhibit rigidity resulting from the original Young's modulus of the ceramic. The wiring board 10 can have higher rigidity due to a through hole formed in the thickness direction with respect to the ceramic layer 100 and a through hole conductor (sometimes called a via conductor) in which the through hole is filled with a conductor material.

### Base Material Wiring Layer 20

The base material wiring layer 20 includes an organic base material layer 200 having an organic resin as an insulating base material (second base material), and the wiring 300. The base material wiring layer 20 is layered on the ceramic layer 100.

### Organic Base Material Layer 200

The organic base material layer 200 illustrated in FIGs. 1 and 2 includes a first organic base material layer 210 (an example of the first layer) and a second organic base material layer 220 (an example of the second layer).

The first organic base material layer 210 has an organic resin as an insulating base material (second base material). The first organic base material layer 210 is layered on the ceramic layer 100. The first organic base material layer 210 is layered on the ceramic layer 100 and closes the through hole 110 of the ceramic layer 100.

The second organic base material layer 220 has an organic resin as an insulating base material (second base material). The second organic base material layer 220 includes a through hole 221 (an example of the fourth through hole). The through hole 221 is located in the center of the second organic base material layer 220 in plan view. The through hole 221 is larger than the through hole 110.

The second organic base material layer 220 is layered on the first organic base material layer 210. The first organic base material layer 210 is layered on the second organic base material layer 220 and closes the through hole 221 of the second organic base material layer 220.

The second base material is a so-called organic base material having an organic material, for example. The second base material may be, for example, an epoxy resin, an acrylic resin, a polycarbonate resin, a polyimide resin, an olefin resin, or a polyphenylene resin. The second base material may be, for example, polytetrafluoroethylene (PTFE) or other fluororesin or polyphenylene ether resin.

### Wiring 300

The wiring 300 illustrated in FIG. 2 includes a first conductor wiring line 311, a second conductor wiring line 321, a third conductor wiring line 322, a first via 312, and a second via 323.

The first conductor wiring line 311 is located in a first wiring layer. The first wiring layer is located on a surface of the organic base material layer 200, the surface being on the ceramic layer 100 side. That is, the first conductor wiring line 311 of the first wiring layer is located on the surface of the first organic base material layer 210.

As illustrated in FIG. 1, a part of the first conductor wiring line 311 is located inside the through hole 110 of the ceramic layer 100 in plan view. In this manner, the first conductor wiring line 311 is partially exposed in the through hole 110 of the ceramic layer 100. This exposed part functions as a connection terminal.

For example, a semiconductor element (not illustrated) is mounted inside the through hole 110 on the surface of the organic base material layer 200. The first conductor wiring line 311 is connected to the semiconductor element by using a bonding wire (not illustrated), for example. The first conductor wiring line 311 is located between the layers of the ceramic layer 100 and the organic base material layer 200. For example, when the thermal expansion coefficient is in order of the ceramic layer 100, the first conductor wiring line 311, and the organic resin layer 200, the first conductor wiring line 311 having an intermediate thermal expansion coefficient among these members is present between the ceramic layer 100 and the organic base material layer 200, whereby the stress generated between the ceramic layer 100 and the organic base material layer 200 can be reduced.

The second conductor wiring line 321 is located in a second wiring layer. The second wiring layer is located on a surface of the second organic base material layer 220, the surface being on the first organic base material layer 210 side. That is, the second conductor wiring line 321 of the second wiring layer is located between the first organic base material layer 210 and the second organic base material layer 220.

The third conductor wiring line 322 is located in a third wiring layer. The third wiring layer is located on a surface of the second organic base material layer 220, the surface being on the opposite side to the first organic base material layer 210. That is, the third conductor wiring line 322 of the third wiring layer is located on a surface of the organic base material layer 200, the surface being on the opposite side to the ceramic layer 100.

The first via 312 penetrates the first organic base material layer 210. The first via 312 electrically connects the first conductor wiring line 311 and the second conductor wiring line 321. The second via 323 penetrates the second organic base material layer 220. The second via 323 electrically connects the second conductor wiring line 321 and the third conductor wiring line 322.

Here, for example, the second via 323 is located farther toward an outer peripheral side of the wiring board 10 than the first via 312. Therefore, for example, the wiring 300 connected to the semiconductor element (not illustrated) is located away from the semiconductor element as the line length becomes longer.

Heat generated in the semiconductor element is dissipated to the outside of the wiring board 10 via the wiring 300. The wiring 300 is located away from the semiconductor element as the line length becomes longer, whereby the heat generated in the semiconductor element can be efficiently dissipated to the outside. In this manner, the wiring 300 also functions as a heat dissipation member of the wiring board 10.

Since the wiring 300 functions as a heat dissipation member, the wiring board 10 does not need to include another heat dissipation member. This enables the wiring board 10 to reduce the number of components while dissipating heat generated in the semiconductor element, for example, and to reduce an increase in the size of the wiring board 10.

In the example in FIG. 2, because the wiring 300 is located away from the semiconductor element as the line length becomes longer, the second and third conductor wiring lines 321 and 322 and the second via 323 are not located in the center of the second organic base material layer 220. Therefore, as illustrated in FIG. 2, the second organic base material layer 220 can be provided with the through hole 221 in the center. By providing the second organic base material layer 220 with the through hole 221, the wiring board 10 can be further reduced in weight.

Here, the first to third wiring layers include the first to third conductor wiring lines 311, 321, and 322, respectively, but the conductors included in the first to third wiring layers are not limited to the conductor wiring lines. For example, the first to third wiring layers may include the above-described linear wiring (first to third conductor wiring lines 311, 321, and 322) and conductors such as a pad in a circular shape or a pad in a polygonal shape. Alternatively, at least one selected from the group consisting of the first to third wiring layers may be a power supply layer or a ground layer including a conductor having a solid shape.

Examples of the material of the wiring 300 include tungsten (W), molybdenum (Mo), a mixture of W-Mo, an alloy of W-Mo, an intermetallic compound of W-Mo, copper, silver, and nickel. The wiring 300 may include a common material such as a ceramic powder.

The first and second vias 312 and 323 may contain, for example, copper powder, tin (Sn) powder, or bismuth (Bi) powder. The first and second vias 312 and 323 may have the same material as the second base material, such as an epoxy resin, as a remnant. The first and second vias 312 and 323 preferably have a melting point closer to the heat-resistant temperature of the base material wiring layer 20 than the heat-resistant temperature of the ceramic layer 100.

### Manufacturing Method

An example of a manufacturing method of the wiring board 10 according to the first embodiment of the present disclosure will be described.

### Manufacturing Method of Ceramic Layer 100

A manufacturing method of the ceramic layer 100 made of a ceramic will be described. The final shape of the ceramic layer 100 is, for example, a quadrilateral plate shape having an area of 10 mm² and a thickness of 1 mm. In the ceramic layer 100, five layers of insulating layers each having a thickness of 0.2 mm, for example, are layered.

The ceramic layer 100 is manufactured from a green sheet made of a ceramic (ceramic green sheet). Examples of the ceramic green sheet include a ceramic material containing alumina as a main component and a glass ceramic.

Examples of the ceramic material containing alumina as a main component include a material in which 10 to 20 parts by mass of SiO₂ and MgO are added to 100 parts by mass of raw material powder of alumina. Other examples of the ceramic material containing alumina as a main component include a material in which 10 to 20 parts by mass of SiO₂ and MgO are added to 100 parts by mass of raw material powder of alumina, and an additive such as MnO is further added. Note that SiO₂ and MgO are desirably added in the same amount. MnO is desirably added in a mass ratio of about 1/10 to 1/2 of the total amount of SiO₂ and MgO. The proportion of SiO₂ is SiO₂/(SiO₂ + MgO) = 40 to 60 in mass ratio, and the remnant is MgO.

Examples of the glass ceramic include those containing inorganic particles such as alumina and silica in borosilicate glass.

As described above, the ceramic layer 100 according to the first embodiment of the present disclosure preferably does not contain a metal component such as a conductor pattern. The ceramic layer 100 preferably does not include a through hole formed in the thickness direction also in this case. Here, the through hole refers to a structure in which a region inside the inner wall is a void.

When the ceramic layer 100 includes the through hole 110, the through hole 110 is formed in the green sheet using a mold or the like. Hereinafter, the green sheet on which the through hole 110 is formed is also called a green sheet for convenience.

Next, the green sheet is fired. In the ceramic material containing alumina as a main component, the green sheet is desirably fired under a condition of 1500°C to 1800°C, for example. In the ceramic material containing a glass ceramic as a main component, the green sheet is desirably fired under a condition of 800°C to 1100°C, for example.

Depending on the thickness of the ceramic layer 100, a plurality of (five in the above-described example) green sheets are layered to manufacture the ceramic layer 100.

### Manufacturing Method of Base Material Wiring Layer 20

A manufacturing method of the base material wiring layer 20 will be described. The final shape of the base material wiring layer 20 is, for example, a quadrilateral plate shape having an area of 10 mm² and a thickness of 0.2 mm. In the base material wiring layer 20, two layers of insulating layers (the first organic base material layer 210 and the second organic base material layer 220) having a thickness of 0.1 mm, for example, are layered.

The base material wiring layer 20 includes a conductor such as the wiring 300. First, an organic resin sheet serving as an organic base material is prepared. A wiring pattern serving as a wiring layer is formed on the surface (both surfaces) of the organic resin sheet.

An interlayer connection conductor (e.g., the first and second vias 312 and 323) oriented in the thickness direction of the insulating layer is formed inside the organic resin sheet. The diameter (via diameter) of the interlayer connection conductor may be 200 µm, for example. As the metal member (e.g., the first to third conductor wiring lines 311, 321, and 322) included in the base material wiring layer 20, copper foil having a thickness of 18 µm, for example, may be used.

The organic resin sheet is prepared by first adjusting varnish added with an inorganic filler such as silica, for example, to an epoxy resin and molding the varnish into a sheet shape.

Next, a conductor is formed on the prepared organic resin sheet. Among the conductors, the interlayer connection conductor described above may be formed by, for example, forming a through hole in the organic resin sheet by forming a hole penetrating in the thickness direction of the organic resin sheet, and filling the through hole with a conductor paste.

As the conductor paste in this case, composite metal powder in which a low-melting-point metal is added to and mixed with copper or silver powder is preferably used as a conductor material, for example. Examples of the low-melting-point metal include tin (Sn), solder (Sn-Pb), bismuth (Bi), and antimony (Sb).

The conductor paste may contain, as a binder, one or more organic resins selected from the group consisting of an epoxy resin, an acrylic resin, a polyethylene resin, and the like. The amount of the binder is desirably 1 to 20 parts by mass with respect to 100 parts by mass of the metal component.

Among the conductors, the ground layer and the wiring may be formed using a copper foil pattern formed by etching copper foil. The copper foil pattern may be processed into a pattern shape by performing each treatment of exposure and development with the copper foil being attached to a resin film. The copper foil pattern obtained by patterning is transferred to the green sheet. For example, transfer is performed by attaching the copper foil pattern to the green sheet, and then peeling off the resin film serving as a base material.

In this manner, the green sheet (pattern sheet) on which the via conductor and the copper foil pattern are formed is prepared.

Note that as described above, the second organic base material layer 220 includes the through hole 221. In this case, the through hole 221 is formed by, for example, forming a through hole having a predetermined shape in the organic resin sheet using a mold or the like.

The pattern sheet described above is layered on the back surface (e.g., in the Z axis negative direction in FIG. 2) side of the ceramic layer 100 as is. Next, the pattern sheet and the ceramic layer 100 are treated under conditions of, for example, a temperature of 70°C, a pressure of about 1 MPa to 5 MPa, and a heating time of 20 seconds to 30 seconds, thereby preparing a layered body. The prepared layered body is cured under conditions of 200°C to 250 C for 2 hours to 4 hours. If necessary, plating (Ni, Au, or the like) may be formed on a conductor surface.

In the base material wiring layer 20, a solder resist may be formed in a region other than the copper foil pattern.

As described above, the ceramic layer 100 and the base material wiring layer 20 according to the first embodiment are formed, and the wiring board 10 in which the ceramic layer 100 and the base material wiring layer 20 are layered is prepared.

### Second Embodiment

In the first embodiment, the semiconductor element (not illustrated) is mounted inside the through hole 110 of the ceramic layer 100, but the mounting place of the semiconductor element is not limited to the inside of the through hole 110. For example, the semiconductor element may be mounted inside the through hole of the base material wiring layer 20.

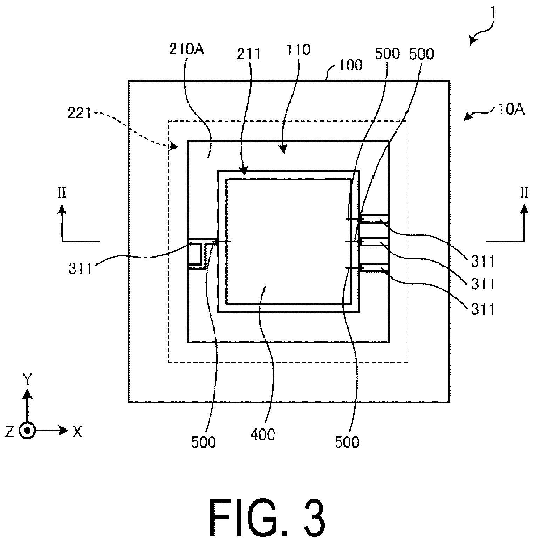

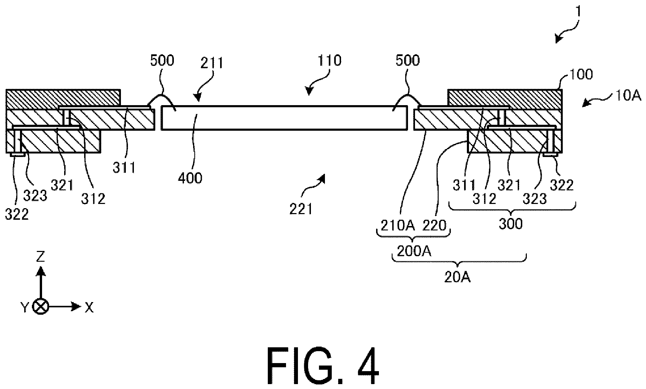

FIG. 3 is a plan view illustrating an example of a semiconductor device 1 according to the second embodiment. FIG. 4 is a cross-sectional view taken along line II-II illustrated in FIG. 3 as viewed in the direction of arrows.

As illustrated in FIGs. 3 and 4, the semiconductor device 1 according to the second embodiment includes a wiring board 10A and a semiconductor element 400. The wiring board 10A and the semiconductor element 400 are electrically connected by a bonding wire 500.

The wiring board 10A according to the second embodiment is different from the wiring board 10 illustrated in FIGs. 1 and 2 in that a first organic base material layer 210A of a base material wiring layer 20A includes a through hole 211. The other configurations are the same as those of the wiring board 10 illustrated in FIGs. 1 and 2, and therefore the same elements are denoted by the same reference signs, and the description thereof will be omitted.

The first organic base material layer 210A includes the through hole 211 (an example of the third through hole). The through hole 211 is located in the center of the first organic base material layer 210A in plan view. The through hole 211 is smaller than the through hole 110. That is, the opening area of the through hole 211 is smaller than the opening area of the through hole 110.

For example, it is assumed that the semiconductor element 400 mounted on the semiconductor device 1 has a light-receiving function as an imaging element. In this case, when the opening area of the through hole 110 is made larger than the opening area of the through hole 211, the semiconductor element 400 can take in more light. Note that in this case, it is assumed that the light receiving surface of the semiconductor element 400 is oriented toward the ceramic layer 100 side (Z axis positive direction).

Since the opening area of the through hole 211 is smaller than the opening area of the through hole 110, a part of the surface of the first organic base material layer 210A is exposed from the through hole 110. A part of the first conductor wiring line 311 is located on the exposed surface of the first organic base material layer 210A. In this manner, since the opening area of through hole 211 is smaller than the opening area of through hole 110, a part of the first conductor wiring line 311 is exposed, and this exposed part functions as a connection terminal with the semiconductor element 400, for example.

As illustrated in FIG. 4, the second organic base material layer 220 includes the through hole 221. In other words, the through hole 211 and the through hole 221 overlap each other in plan view in the first organic base material layer 210A and the second organic base material layer 220. That is, the base material wiring layer 20A includes a through hole (an example of the second through hole) formed by the through hole 211 and the through hole 221.

In this manner, the base material wiring layer 20A (organic base material layer 200A) includes through holes having different diameters in the respective organic base material layers in the organic base material layer 200A in which two layers overlap. That is, the first organic base material layer 210A includes the through hole 211, which is a part of the through hole. The second organic base material layer 220 includes the through hole 221 (an example of the fourth through hole), which is a part of the through hole. In this case, the through hole 221 is larger in inner diameter than the through hole 211. In the wiring board 10A according to the second embodiment, the ceramic layer 100, the first organic base material layer 210A, and the second organic base material layer 210A are layered and disposed in this order, and the inner diameters of the through holes provided in the respective layers are arranged in descending order of the through hole 221 of the second organic base material layer 220, the through hole 110 of the ceramic layer 100, and the through hole 211 of the first organic base material layer 210A. In the layered body in which the ceramic layer 100, the first organic base material layer 210A, and the second organic base material layer 220 are layered in this order, the inner diameter of the through hole 211 formed in the first organic base material layer 210A located at a middle stage in the layering direction is the smallest. On the other hand, the inner diameter of each of the through hole 110 of the ceramic layer 100 and the through hole 221 of the second organic base material layer 210A located on an outer side in the layering direction is larger than the inner diameter of the through hole 211 formed in the first organic base material layer 210A.

The semiconductor element 400 is mounted inside the through hole 211 of the base material wiring layer 20A. At this time, the semiconductor element 400 is preferably mounted to have a connection terminal (not illustrated) of the semiconductor element 400 being located on the same plane as the first conductor wiring line 311. In other words, the surface of the semiconductor element 400 is preferably located on the same plane as the surface of the base material wiring layer 20A.

Since the surface of the semiconductor element 400 is located on the same plane as the surface of the base material wiring layer 20A, the distance between the connection terminal of the semiconductor element 400 and the first conductor wiring line 311 is shortened. Therefore, the length of the bonding wire 500 connecting the semiconductor element 400 and the first conductor wiring line 311 is shortened, and the resistance or inductance of the bonding wire 500 can be reduced.

As described above, the semiconductor device 1 according to the second embodiment of the present disclosure includes the semiconductor element 400 mounted inside the through hole 211 of the first organic base material layer 210A. Due to this, the semiconductor element 400 is hardly affected by deformation of the base material wiring layer 20A and the ceramic layer 100. Therefore, the semiconductor device 1 can further reduce the failure probability due to deformation of the semiconductor element 400.

Since the semiconductor device 1 includes the semiconductor element 400 located in the same layer as the first organic base material layer 210A, the semiconductor device 1 can have a shortened length of the wiring (e.g., the bonding wire 500) connecting the semiconductor element 400 and the first conductor wiring line 311.

### Third Embodiment

In the second embodiment, the semiconductor device 1 includes the semiconductor element 400 mounted inside the through hole of the base material wiring layer 20, but the semiconductor device 1 may further include a metal plate.

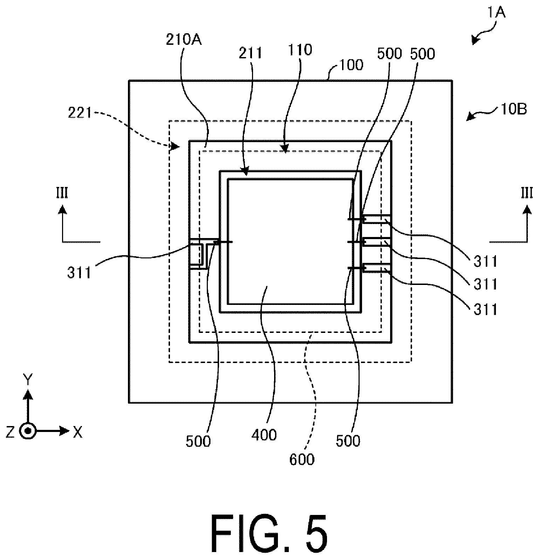

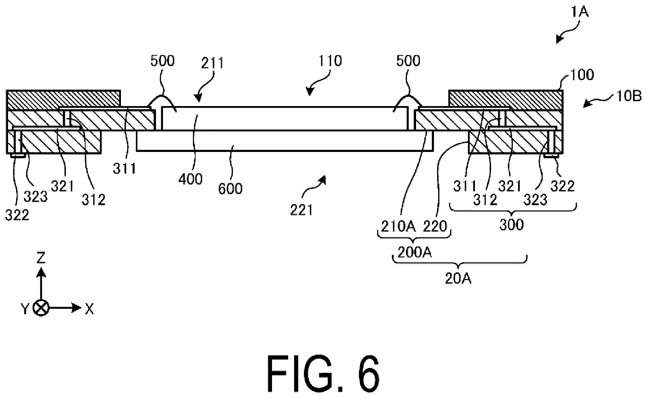

FIG. 5 is a plan view illustrating an example of a semiconductor device 1A according to the third embodiment. FIG. 6 is a cross-sectional view taken along line III-III illustrated in FIG. 5 as viewed in the direction of arrows.

As illustrated in FIGs. 5 and 6, the semiconductor device 1A according to the third embodiment includes a wiring board 10B and the semiconductor element 400. The wiring board 10B and the semiconductor element 400 are electrically connected by the bonding wire 500.

The wiring board 10B according to the third embodiment is different from the wiring board 10A illustrated in FIGs. 3 and 4 in further including a metal plate 600. The other configurations are the same as those of the wiring board 10A illustrated in FIGs. 3 and 4, and therefore the same elements are denoted by the same reference signs, and the description thereof will be omitted.

The metal plate 600 is located inside the through hole 221 of the second organic base material layer 220. The metal plate 600 is layered on the base material wiring layer 20A on the side opposite to the ceramic layer 100. More specifically, the metal plate 600 is layered on the first organic base material layer 210A on the side opposite to the ceramic layer 100. The metal plate 600 is in contact with a surface among the two surfaces of the first organic base material layer 210A on the opposite side to the surface in contact with the ceramic layer 100.

The metal plate 600 covers at least a part of, for example, the through hole of the base material wiring layer 20A more specifically, the through hole 211 of the first organic base material layer 210A. In the example of FIG. 5, the metal plate 600 covers the entire through hole 211 of the first organic base material layer 210A, that is, closes the through hole 211. In other words, the size of the metal plate 600 is larger than the opening area of the through hole 211 of the first organic base material layer 210A. Here, the size of the metal plate 600 is the area of the surface when the wiring board 10 is viewed from the layering direction. The area of the metal plate 600 is the area of one surface among the two surfaces of the metal plate 600.

The size of the metal plate 600 is smaller than the size of the through hole 110 of the ceramic layer 100. That is, the area of the metal plate 600 is smaller than the opening area of the through hole 110 of the ceramic layer 100.

The Young's modulus of the metal plate 600 is smaller than the Young's modulus of the ceramic layer 100 and larger than the Young's modulus of the base material wiring layer 20A. The metal plate 600 includes, for example, Cu, Al, stainless steel, or the like.

The semiconductor element 400 is mounted on a surface (front surface) on the ceramic layer 100 side among the two surfaces of the metal plate 600. That is, the surface of the semiconductor element 400 is in contact with the surface of the metal plate 600 on the ceramic layer 100 side. The metal plate 600 functions as a mounting portion of the semiconductor element 400 and also functions as a heatsink for releasing excessive heat generated in the semiconductor element 400 to the outside.

As illustrated in FIG. 6, the base material wiring layer 20A (in particular, the first organic base material layer 210A) is sandwiched between the ceramic layer 100 and the metal plate 600. As described above, the Young's modulus of the metal plate 600 is smaller than the Young's modulus of the ceramic layer 100 and larger than the Young's modulus of the base material wiring layer 20A. That is, in the wiring board 10B of the present disclosure, the base material wiring layer 20A having the lowest Young's modulus is sandwiched from both sides between the ceramic layer 100 and the metal plate 600 that are higher in Young's modulus than the base material wiring layer 20A. Therefore, the wiring board 10B is less likely to be deformed than the wiring boards 10 and 10A of the first and second embodiments.

The metal plate 600 covers the entire through hole 211 of the first organic base material layer 210A. Due to this, the metal plate 600 plays a role of enhancing the strength of the region of the through hole of the base material wiring layer 20A. The ceramic layer 100 is located around the through hole 211 of the first organic base material layer 210A. Thus, the ceramic layer 100 plays a role of enhancing the strength around the through hole of the base material wiring layer 20A. In this manner, by including the ceramic layer 100 and the metal plate 600, the semiconductor device 1A can enhance the strength of the entire base material wiring layer 20A.

The ceramic layer 100 having the highest Young's modulus is located around the through hole of the base material wiring layer 20A, and the metal plate 600 lower in Young's modulus than the ceramic layer 100 is located in a region inside the through hole. In this manner, since the ceramic layer 100 holds the peripheral edge of the wiring board 10B, the semiconductor device 1A can suppress deformation of the entire wiring board 10B to a smaller extent.

The semiconductor element 400 is located on a surface of the metal plate 600, the surface being on the ceramic layer 100 side. Due to this, the ceramic layer 100 and the base material wiring layer 20A (in particular, the first organic base material layer 210A) have a structure surrounding the semiconductor element 400. That is, a wall member made of the ceramic layer 100 and the base material wiring layer 20A is located around the mounting portion of the metal plate 600 on which the semiconductor element 400 is mounted.

Therefore, the position of the height (the surface on the ceramic layer 100 side) of the semiconductor element 400 is close to the position of the surface (the surface on the ceramic layer 100 side) of the base material wiring layer 20A. In other words, the position of the height (the surface on the ceramic layer 100 side) of the semiconductor element 400 is close to the position of the first conductor wiring line 311.

This enables the semiconductor device 1A to have a further shortened length of the bonding wire 500 passing from the semiconductor element 400 to the first conductor wiring line 311 located on the surface of the base material wiring layer 20A. The semiconductor device 1A can reduce the resistance or inductance of the bonding wire 500.

Note that at this time, the thickness of the first organic base material layer 210A is preferably about the same as the thickness of the semiconductor element 400. Due to this, the surface of the semiconductor element 400 on the ceramic layer 100 side is located on the same plane as the surface of the base material wiring layer 20A, and the length of the bonding wire 500 is further shortened.

In addition to a method of measuring the Young's modulus using a sample piece cut out from the semiconductor device 1A, a value obtained by separately preparing a member corresponding to the composition of each base material and measuring the Young's modulus may be used. The term "main component" used here refers to a component contained in the base material in the largest amount in terms of mass ratio or volume ratio.

### Fourth Embodiment

In the third embodiment, the semiconductor device 1A further includes the metal plate 600, but the semiconductor device 1A may further include a lid body.

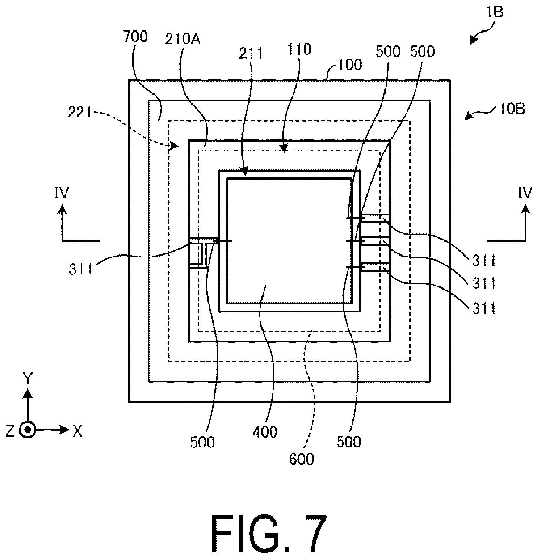

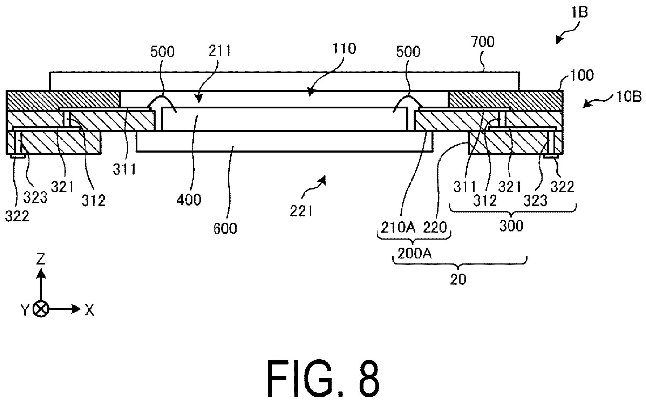

FIG. 7 is a plan view illustrating an example of a semiconductor device 1B according to the fourth embodiment. FIG. 8 is a cross-sectional view taken along line IV-IV illustrated in FIG. 7 as viewed in the direction of arrows.

As illustrated in FIGs. 7 and 8, the semiconductor device 1B according to the fourth embodiment includes the wiring board 10B, the semiconductor element 400, and a lid body 700. The wiring board 10B and the semiconductor element 400 are electrically connected by the bonding wire 500.

The semiconductor device 1B according to the fourth embodiment is different from the semiconductor device 1A illustrated in FIGs. 5 and 6 in further including the lid body 700. The other configurations are the same as those of the semiconductor device 1A illustrated in FIGs. 5 and 6, and therefore the same elements are denoted by the same reference signs, and the description thereof will be omitted.

The lid body 700 is in contact with a surface among the two surfaces of the ceramic layer 100 on the surface opposite to the base material wiring layer 20A. The lid body 700 closes the through hole 110 of the ceramic layer 100. The semiconductor element 400 is hermetically sealed by the lid body 700 and the wiring board 10B.

The lid body 700 illustrated in FIGs. 5 and 6 is formed in a flat plate shape. As described above, the semiconductor element 400 is located inside the through hole of the base material wiring layer 20A. The ceramic layer 100 including the through hole 110 is layered on the base material wiring layer 20A. Therefore, the surface of the semiconductor element 400 on the ceramic layer 100 side is located at a position (Z axis negative direction side) lower than the surface in contact with the lid body 700 of the ceramic layer 100. In this manner, since the semiconductor element 400 has a structure not protruding from the through hole 110 of the ceramic layer 100, the semiconductor device 1B can hermetically seal the semiconductor element 400 using the lid body 700 having a flat plate shape.

For example, when the semiconductor element 400 mounted on the semiconductor device 1B has a light-receiving function as an imaging element, the lid body 700 includes a member having translucency such as glass, for example.

The entire lid body 700 may have translucency, or a part thereof may have translucency. When a part of the lid body 700 has translucency, for example, a region corresponding to the through hole 110 of the ceramic layer 100 has translucency. The region corresponds to a region that can be imaged by the semiconductor element 400 that is an imaging element, for example.

The region having translucency of the lid body 700 is preferably larger than the opening area of the through hole 110 of the ceramic layer 100. When the region having translucency of the lid body 700 is made larger than the opening area of the through hole 110, the semiconductor element 400 can take in more light.

The lid body 700 may have a shape other than the flat plate shape. For example, the lid body 700 may have a shape in which the center region is expanded. In this manner, the lid body 700 may have a function as a lens. In this case, the semiconductor device 1B may further include a lens holder that supports the lid body 700. Alternatively, the ceramic layer 100 may have a function as a lens holder that supports the lid body 700.

By layering the lid body 700 on the ceramic layer 100, the semiconductor device 1B can further reduce the positional deviation or optical axis deviation of the lid body 700 due to thermal deformation, for example, as compared with the case where the lid body 700 is installed on the base material wiring layer 20A. Thus, the durability of the semiconductor device 1B is further improved.

The Young's modulus of the ceramic layer 100 may be higher than the Young's modulus of the lid body 700. As described above, the Young's modulus of the base material wiring layer 20A is smaller than the Young's modulus of the ceramic layer 100. When the semiconductor device 1B is viewed in the layering direction, in the semiconductor device 1B, the lid body 700, the ceramic layer 100, and the base material wiring layer 20A are layered in this order. In such a layering structure, since the ceramic layer 100 having a high Young's modulus is located in the center in the layering direction, the ceramic layer 100 serves as a base axis, and the entire semiconductor device 1B is more resistant to deformation.

### Fifth Embodiment

In the fourth embodiment described above, a corner on the through hole 110 side, the corner being the surface of the ceramic layer 100 on the opposite side to the base material wiring layer 20A, is formed at a right angle. A corner on the through hole 211 side, the corner being the surface of the base material wiring layer 20A on the ceramic layer 100 side, is formed at a right angle. However, the shape of the corner is not limited to a right angle. For example, the corner may be formed in an inclined surface shape or a curved surface shape.

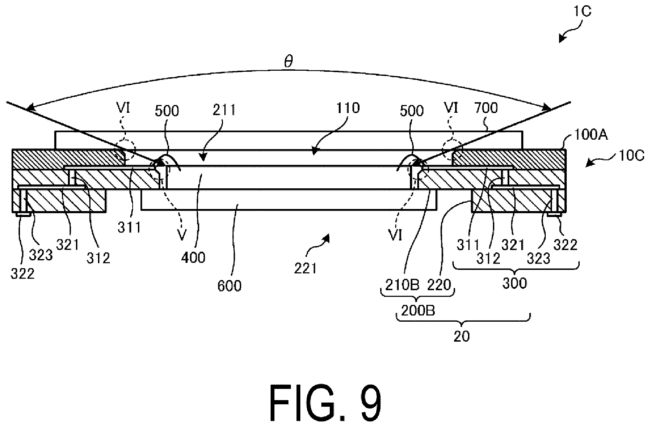

FIG. 9 is a cross-sectional view illustrating an example of a semiconductor device 1C according to the fifth embodiment. The semiconductor device 1C is different from the semiconductor device 1B illustrated in FIGs. 7 and 8 in that a corner of a ceramic layer 100A and a corner of a first organic base material layer 200B of the organic base material layer 210B are inclined. The other configurations are the same as those of the semiconductor device 1B illustrated in FIGs. 7 and 8, and therefore the same elements are denoted by the same reference signs, and the description thereof will be omitted.

A corner on the through hole 110 side, the corner being a surface of the ceramic layer 100A on the opposite side to the base material wiring layer 20B, and a corner (see regions V and VI illustrated in FIG. 9) on the through hole 211 side, the corner being a surface of the first organic base material layer 210B on the ceramic layer 100A side, have an inclined surface shape (e.g., C plane shape).

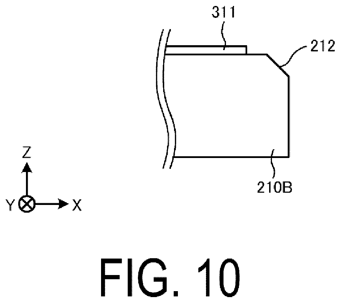

FIG. 10 is an enlarged view of the region V illustrated in FIG. 9. FIG. 10 illustrates an enlarged view of a corner of the first organic base material layer 210B. In FIG. 10, components other than the first organic base material layer 210B and the first conductor wiring line 311 are not illustrated.

As illustrated in FIG. 10, the first organic base material layer 210B has an inclined surface 212. The inclined surface 212 is formed at a corner on the through hole 211 side, the corner being a surface of the first organic base material layer 210B on the ceramic layer 100A side. In this manner, the edge of the through hole 211 of the first organic base material layer 210B is inclined downward toward a mounting region (e.g., the metal plate 600) side of the semiconductor element 400.

Similarly, the ceramic layer 100A has an inclined surface. The inclined surface is formed at a corner on the through hole 110 side, the corner being a surface of the ceramic layer 100A on the lid body 700 side. In this manner, the edge of the through hole 110 of the ceramic layer 100A is inclined downward toward the mounting region (e.g., the metal plate 600) side of the semiconductor element 400.

In this manner, since the corners of the ceramic layer 100A and the first organic base material layer 210B are inclined, an inclination angle θ illustrated in FIG. 9 is larger. This allows the semiconductor element 400 to take in more light.

Note that in FIGs. 9 and 10, the corners of the ceramic layer 100A and the first organic base material layer 210B are inclined in a planar shape (have an inclined surface shape), but for example, the corners may be inclined in a curved surface shape. That is, the corners of the ceramic layer 100A and the first organic base material layer 210B may be formed in a curved surface shape.

In FIG. 9, both corners of the ceramic layer 100A have an inclined surface shape or a curved surface shape, but at least one corner may have an inclined surface shape or a curved surface shape. That is, any one corner of the ceramic layer 100A may have a right angle shape. Both corners of the first organic base material layer 210B have an inclined surface shape or a curved surface shape, but at least one corner may have an inclined surface shape or a curved surface shape. That is, any one corner of the first organic base material layer 210B may have a right angle shape.

### Sixth Embodiment

In the second embodiment described above, the opening area of the through hole 110 of the ceramic layer 100 is smaller than the opening area of the through hole 221 of the second organic base material layer 220, but the opening area of the through hole 110 of the ceramic layer 100 is not limited to this. For example, the opening area of the through hole 110 of the ceramic layer 100 may be larger than the opening area of the through hole 221 of the second organic base material layer 220.

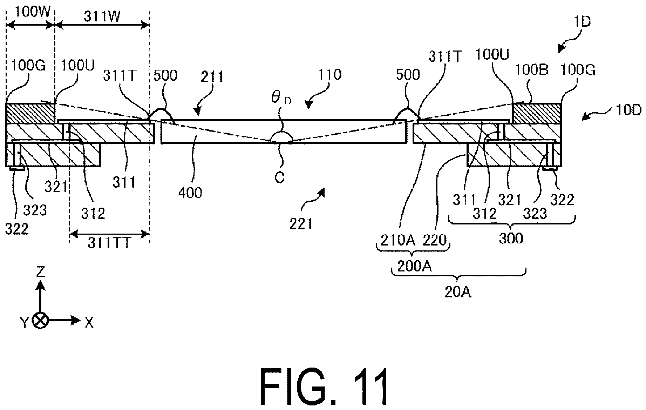

FIG. 11 is a cross-sectional view illustrating an example of a semiconductor device 1D according to the sixth embodiment. The semiconductor device 1D illustrated in FIG. 11 includes a wiring board 10D. The wiring board 10D has the same configuration as that of the wiring board 10A illustrated in FIG. 4 except that a ceramic layer 100B is included in place of the ceramic layer 100.

In the wiring board 10D illustrated in FIG. 11, the ceramic layer 100B, the first organic base material layer 210A, and the second organic base material layer 220 are layered and disposed in this order.

In the present embodiment, the inner diameters of the through holes provided in the respective layers constituting the wiring board 10D are arranged in a descending order of the through hole 110 of the ceramic layer 100D, the through hole 221 of the second organic base material layer 220, and the through hole 211 of the first organic base material layer 210A.

In the layered body in which the ceramic layer 100B, the second organic base material layer 220, and the first organic base material layer 210A are layered in this order, the inner diameter of the through hole 211 formed in the first organic base material layer 210A located at a middle stage in the layering direction is the smallest. On the other hand, the inner diameter of each of the through hole 110 of the ceramic layer 100B and the through hole 221 of the second organic base material layer 210A located on an outer side in the layering direction is larger than the inner diameter of the through hole 211 formed in the first organic base material layer 210A.

In this case, the through hole 110 of the ceramic layer 100B is larger than the inner diameter of the through hole 221 of the second organic base material layer 210A.

According to the wiring board 10D of the sixth embodiment, the position of an inner edge 100U forming the through hole 110 of the ceramic layer 100B approaches an outer side 100G side of the ceramic layer 100B. Therefore, as compared with the wiring board 10A of the second embodiment described above, an angle θ_{D} centered on the mounting position (position of reference sign C) of the semiconductor element 400 is larger.

In other words, an incident angle θ_{D} of light to the semiconductor element increases. When the semiconductor element 400 is a light receiving element such as an image sensor, the amount of received light can be increased. As a result, an image obtained by the light receiving element can be made clearer.

In the wiring board 10D of the sixth embodiment, since the position of the inner edge 100U forming the through hole 110 of the ceramic layer 100B approaches the outer side 100G side of the ceramic layer 100B, the volume of the ceramic layer 100B decreases.

As a result, the wiring board 10D of the sixth embodiment can be made lighter in weight than the wiring board 10A of the second embodiment.

When the weight of the wiring board 10D is reduced, the amount of displacement due to inertia caused by the weight of the wiring board 10D itself can be reduced in a case where the wiring board 10D is movable.

When the light receiving element is an imaging element, blurring of a captured image based on the ground time difference at the time of imaging can be reduced.

The wiring board 10D of the sixth embodiment has a larger area in which the first conductor wiring line 311 is exposed on the surface of the first organic base material layer 210 as compared with the wiring board 10A of the second embodiment. Heat dissipation from first conductor wiring line 311 can be enhanced.

As illustrated in FIG. 11, when the first organic base material layer 210 includes the first via 312 and this first via 312 is electrically connected to the first conductor wiring line 311, the position of the first via 312 is preferably closer to the center position (corresponding to the position of reference sign C) of the through hole 110 than the position of the inner edge 100U of the ceramic layer 100B in plan perspective view of the wiring board 10D.

Since the ceramic layer 100B does not overlap the first via 312, heat dissipation from the first via 312 is also improved.

In this case, a width 100W from the outer side 100G of the ceramic layer 100B to the inner edge 100U of the ceramic layer 100B is preferably narrower than a width 311W of the first conductor wiring line 311 exposed on the first organic base material layer 210 for the reason that the heat dissipation from the wiring board 10D can be improved.

In other words, the width 311W of the first conductor wiring line exposed on the first organic base material layer 210 is preferably wider than the width 100W from the outer side 100G of the ceramic layer 100B to the inner edge 100U of the ceramic layer 100B.

Here, the width 100W from the outer side 100G of the ceramic layer 100B to the inner edge 100U of the ceramic layer 100B and the width 311W of the first conductor wiring line 311 exposed on the first organic base material layer 210 are both widths in a part of the wiring board 10D viewed in cross section as illustrated in FIG. 11.

That is, in the wiring board 10D, the width 311W of the first conductor wiring line 311 exposed on the first organic base material layer 210 preferably has a part larger than the width 100W from the outer side 100G of the ceramic layer 100B to the inner edge 100U of the ceramic layer 100B for the reason that the heat dissipation can be improved.

Furthermore, in this wiring board 10D, as described above, the width from the outer side 100G of the wiring board 10D to the center position C of the through hole 110 is wider in the first organic base material layer 210 and the second organic base material layer 220 than in the ceramic layer 100B, and thus the volume of the organic resin base material is larger when the volume of a ceramic base material is compared with the volume of an organic resin base material.

In the wiring board 10D, the wiring board 10D is easily bent due to the volume fraction of the ceramic base material being low.

In the wiring board 10D, a force with which the ceramic layer 100B suppresses or restrains the first organic base material layer 210 and the second organic base material layer 220 is weak.

Due to this, mounting reliability (also called secondary mounting reliability) between the wiring board 10D and an external large base material such as an external circuit board is enhanced.

In the wiring board 10D, a width 31 1TT from the position of the first via 312 included in the first organic base material layer 210 constituting the middle layer of the three-layer structure to an end 311T (also called a first conductor wiring line end 31 1T) of the first conductor wiring line 311 is preferably larger than the width 100W of the ceramic layer 100.

### Other Embodiments

In the embodiments described above, the color tones of the ceramic layers 100 and 100A and the base material wiring layers 20, 20A, and 20B may be black. Here, black includes a mixture of brown, deep blue, or the like.

When the color tones of the ceramic layers 100 and 100A and the base material wiring layers 20, 20A, and 20B are black, irregular reflection of the wiring board 10, 10A, and 10B is suppressed, and for example, the light receiving efficiency of the semiconductor element 400 as an imaging element is improved. Black ceramic is excellent in thermal radiation.

Examples of black ceramic include ceramics such as silicon nitride and silicon carbide. Examples thereof include ceramics in which a black pigment is mixed with aluminum oxide or zirconium oxide. In this case, examples of the black pigment include oxides such as iron, manganese, titanium, and cobalt.

When the color tones of the ceramic layers 100 and 100A and the base material wiring layers 20, 20A, and 20B are black, the blackness of the ceramic layers 100 and 100A is assumed to be higher than the blackness of the base material wiring layers 20, 20A, and 20B. Alternatively, the blackness of the base material wiring layers 20, 20A, and 20B may be higher than the blackness of the ceramic layers 100 and 100A.

In this manner, since the blackness of the ceramic layers 100 and 100A is different from the blackness of the base material wiring layers 20, 20A, and 20B, for example, the light receiving efficiency and the light receiving sensitivity of the semiconductor element 400 as an imaging element are improved.

Note that in the embodiments described above, the ceramic layers 100 and 100A, the base material wiring layers 20, 20A, and 20B, the metal plate 600, and the lid body 700 have a square shape in plan view, but these shapes are not limited to the square shape. The ceramic layers 100 and 100A, the base material wiring layers 20, 20A, and 20B, the metal plate 600, and the lid body 700 may have a rectangular shape or a polygonal shape in plan view.

In the embodiments described above, the through holes 110, 211, and 221 have a square shape in plan view, but these shapes are not limited to the square shape. The through holes 110, 211, and 221 may have a rectangular shape or a polygonal shape in plan view.

As described above, the wiring board 10 and 10A to 10C according to the respective embodiments have a layered body including the ceramic layers 100 and 100A made of a ceramic, and the base material wiring layers 20, 20A, 20B each having an organic resin as a base material and including the wiring 300. The base material wiring layers 20, 20A, and 20B include the first conductor wiring line 311 made of copper foil serving as connection terminals on the surfaces of the ceramic layers 100 and 100A.

This allows the wiring boards 10 and 10A to 10C according to the respective embodiments to reduce the resistance of the first conductor wiring line 311 while having high rigidity.

Further effects and other aspects can be easily derived by those skilled in the art. Thus, a wide variety of aspects of the present disclosure are not limited to the specific details and representative embodiments represented and described above. Accordingly, various changes are possible without departing from the spirit or scope of the general inventive concepts defined by the appended claims and their equivalents.

### REFERENCE SIGNS

1, 1A, 1B, 1C Semiconductor device
10, 10A, 10B Wiring board
20, 20A, 20B Base material wiring layer
100, 100A Ceramic layer
110, 211, 221 Through hole
200, 200A, 200B Organic base material layer
210, 210A, 210B First organic base material layer
212 Inclined surface
220 Second organic base material layer
300 Wiring
311 First conductor wiring line
312 First via
321 Second conductor wiring line
322 Third conductor wiring line
323 Second via
400 Semiconductor element
500 Bonding wire
600 Metal plate
700 Lid body

## Claims

1. A wiring board comprising:
a layered body comprising a ceramic layer made of a ceramic and a base material wiring layer having an organic resin as a base material and comprising a wiring layer, wherein
the base material wiring layer comprises a conductor wiring line made of copper foil on a surface on the ceramic layer side.

2. The wiring board according to claim 1, wherein
the ceramic layer is a monolithic ceramic.

3. The wiring board according to claim 1 or 2, wherein
the ceramic layer has a first through hole in a center as viewed from a layering direction,
the base material wiring layer has a second through hole in a center as viewed from the layering direction,
the first through hole and the second through hole overlap each other as viewed from the layering direction, and
a semiconductor element is disposed in the second through hole.

4. The wiring board according to claim 3, wherein
an opening area of the second through hole is smaller than an opening area of the first through hole.

5. The wiring board according to claim 3 or 4, wherein
a part of the conductor wiring line is located inside the first through hole on the surface of the base material wiring layer as viewed from the layering direction.

6. The wiring board according to any one of claims 3 to 5, wherein
the base material wiring layer comprises
a first layer in contact with the ceramic layer, and
a second layer located on an opposite side to the ceramic layer across the first layer,
the first layer has a third through hole, which is a part of the second through hole, in a center as viewed from the layering direction,
the second layer has a fourth through hole, which is a part of the second through hole, in a center as viewed from the layering direction, and
an opening area of the fourth through hole is larger than an opening area of the third through hole and larger than the first through hole.

7. The wiring board according to claim 6, wherein
the base material wiring layer further comprises a first via penetrating the first layer and a second via penetrating the second layer, and
the second via is located farther toward an outer peripheral side of the base material wiring layer than the first via.

8. The wiring board according to any one of claims 3 to 7, further comprising:
a metal plate layered on the base material wiring layer on an opposite side to the ceramic layer side, wherein
the metal plate covers at least a part of the second through hole of the base material wiring layer, and
a Young's modulus of the metal plate is smaller than a Young's modulus of the ceramic layer and larger than a Young's modulus of the base material wiring layer.

9. The wiring board according to claim 8, wherein
an area of the metal plate is smaller than an opening area of the first through hole.

10. The wiring board according to claim 8 or 9, wherein
the semiconductor element is located on a surface of the metal plate on the ceramic layer side.

11. The wiring board according to any one of claims 8 to 10, wherein
the semiconductor element is mounted and a connection terminal of the semiconductor element is located on a same plane as the conductor wiring line of the base material wiring layer.

12. The wiring board according to any one of claims 3 to 11, wherein
on a surface on an opposite side to the base material wiring layer side, the ceramic layer has a corner on the first through hole side, the corner being formed in an inclined surface shape or a curved surface shape.

13. The wiring board according to any one of claims 3 to 12, wherein
on the surface on the ceramic layer side, the base material wiring layer has a corner on the second through hole side, the corner being formed in an inclined surface shape or a curved surface shape.

14. A semiconductor device comprising:
a layered body comprising a ceramic layer made of a ceramic and a base material wiring layer having an organic resin as a base material and comprising a wiring layer; and
a semiconductor element mounted on the layered body, wherein
the base material wiring layer comprises a conductor wiring line made of copper foil on a surface on the ceramic layer side.
